# FASCICULE DE BREVET EUROPEEN

(11) **EP 4 226 416 B1**
(45) Date de publication et mention de la délivrance du brevet: **23.10.2024**
(21) Numéro de dépôt: 21801584.0
(22) Date de dépôt: 04.10.2021
(51) Int. Cl.: H01L 21/02, H01L 21/762

(54) **PROCÉDÉ DE FABRICATION D'UN SUBSTRAT POUR LA CROISSANCE ÉPITAXIALE D'UNE COUCHE D'UN ALLIAGE III-N À BASE DE GALLIUM**
VERFAHREN ZUR HERSTELLUNG EINES SUBSTRATS FÜR DAS EPITAKTISCHE WACHSTUM EINER SCHICHT AUS EINER GALLIUMBASIERTEN III-N-LEGIERUNG
METHOD FOR PRODUCING A SUBSTRATE FOR THE EPITAXIAL GROWTH OF A LAYER OF A GALLIUM-BASED III-N ALLOY

(30) Priorité: 06.10.2020 FR 2010209
(43) Date de publication de la demande: 16.08.2023
(73) Titulaire: SOITEC, 38190 Bernin (FR)
(72) Inventeur: GUIOT, Eric, 38190 BERNIN (FR)
(74) Mandataire: Regimbeau
(86) Numéro de dépôt international: PCT/FR2021/051708
(87) Numéro de publication internationale: WO 2022/074317

(56) Documents cités:
- EP-A1- 1 653 504
- FR-A1- 2 840 731
- US-A1- 2015 214 040

## Description

### Domaine technique

La présente invention concerne un procédé de fabrication d'un substrat pour la croissance épitaxiale d'une couche d'un alliage III-N à base de gallium (c'est-à-dire une couche de nitrure de gallium (GaN), de nitrure d'aluminium et de gallium (AIGaN) ou une couche de nitrure de gallium et d'indium (InGaN)), ainsi qu'un procédé de fabrication d'une telle couche d'alliage III-N et un procédé de fabrication d'un transistor à haute mobilité d'électrons (HEMT) dans une telle couche d'alliage III-N.

### Etat de la technique

Les matériaux semi-conducteurs III-N, en particulier le nitrure de gallium (GaN), le nitrure d'aluminium et de gallium (AIGaN) ou le nitrure de gallium et d'indium (InGaN), apparaissent particulièrement prometteurs notamment pour la formation de diodes électroluminescentes (LEDs) de forte puissance et de dispositifs électroniques fonctionnant à haute fréquence, tels que des transistors à haute mobilité d'électrons (HEMTs) ou d'autres transistors à effet de champ (FETs).

Dans la mesure où ces alliages III-N sont difficiles à trouver sous la forme de substrats massifs de grande dimension, ils sont généralement formés par hétéoépitaxie, c'est-à-dire par épitaxie sur un substrat constitué d'un matériau différent.

Le choix d'un tel substrat prend en compte en particulier la différence de paramètre de maille et la différence de coefficient de dilatation thermique entre le matériau du substrat et l'alliage III-N. En effet, plus ces différences sont importantes, plus les risques de formation dans la couche d'alliage III-N de défauts cristallins, tels que des dislocations, et la génération de contraintes mécaniques importantes, susceptibles de provoquer des déformations excessives, sont grands.

Les matériaux les plus fréquemment considérés pour l'hétéroépitaxie d'alliages III-N sont le saphir et le carbure de silicium (SiC).

Outre sa plus faible différence de paramètre de maille avec le nitrure de gallium, le carbure de silicium est particulièrement préféré pour les applications électroniques de forte puissance en raison de sa conductivité thermique qui est nettement supérieure à celle du saphir et qui permet par conséquent de dissiper plus facilement l'énergie thermique générée lors du fonctionnement des composants.

Pour les applications radiofréquences (RF), on cherche à utiliser du carbure de silicium semi-isolant, c'est-à-dire présentant typiquement une résistivité électrique supérieure ou égale à 10⁵ Ω.cm, afin de minimiser les pertes parasites (généralement appelées pertes RF) dans le substrat. Cependant, ce matériau est particulièrement onéreux et ne se trouve actuellement que sous la forme de substrats de dimension limitée.

Le silicium permettrait de réduire drastiquement les coûts de fabrication et d'accéder à des substrats de grande dimension, mais les structures de type alliage III-N sur silicium sont pénalisées par des pertes RF de propagation au-delà de 20 GHz et par une faible dissipation thermique.

Des structures composites, telles que des structures SopSiC ou SiCopSiC, ont également été investiguées [1] mais ne se révèlent pas totalement satisfaisantes. Ces structures comprennent respectivement une couche de silicium monocristallin ou une couche de SiC monocristallin (destinée à former une couche germe pour la croissance épitaxiale du nitrure de gallium) sur un substrat de SiC polycristallin. Bien que le SiC polycristallin soit un matériau peu onéreux, disponible sous la forme de substrats de grande dimension et procurant une bonne dissipation thermique, ces structures composites sont pénalisées par la présence d'une couche d'oxyde de silicium à l'interface entre la couche de silicium ou de SiC monocristallin et le substrat de SiC polycristallin, qui forme une barrière thermique entravant la dissipation de chaleur de la couche d'alliage III-N vers le substrat de SiC polycristallin.

US 2015/214040 A1 divulgue un procédé de fabrication d'un substrat pour des composants de puissance.

### Brève description de l'invention

Un but de l'invention est donc de remédier aux inconvénients précités et notamment aux limitations liées à la taille et au coût des substrats de SiC semi-isolant.

L'invention a donc pour but de concevoir un procédé de fabrication d'un substrat pour la croissance épitaxiale d'un alliage III-N à base de gallium, notamment en vue de la formation de transistors HEMT ou d'autres dispositifs électroniques à haute fréquence et forte puissance dans lesquels les pertes RF sont minimisées et la dissipation thermique est maximisée.

A cet effet, l'invention propose un procédé de fabrication d'un substrat pour la croissance épitaxiale d'une couche de nitrure de gallium (GaN), de nitrure de gallium et d'aluminium (AIGaN) ou de nitrure de gallium et d'indium (InGaN), comprenant les étapes successives suivantes :
- fourniture d'un substrat donneur de carbure de silicium monocristallin,
- implantation d'espèces ioniques dans le substrat donneur de sorte à former une zone de fragilisation délimitant une couche mince de SiC monocristallin à transférer,
- collage du substrat donneur sur un premier substrat receveur par l'intermédiaire d'une couche de collage,
- détachement du substrat donneur le long de la zone de fragilisation de sorte à transférer la couche mince de SiC sur le premier substrat receveur,
- croissance épitaxiale d'une couche (30) de SiC semi-isolant présentant une épaisseur supérieure à 1 µm sur la couche mince de SiC,
- collage de la couche de SiC semi-isolant sur un second substrat receveur, ledit second substrat receveur présentant une haute résistivité électrique,
- retrait d'au moins une partie de la couche de collage de sorte à détacher le premier substrat receveur,
- retrait de la couche mince de SiC monocristallin transférée, de sorte à exposer la couche de SiC semi-isolant.

Par « haute fréquence », on entend dans le présent texte une fréquence supérieure à 3 kHz.

Par « forte puissance », on entend dans le présent texte une puissance supérieure à 0,5W/mm injectée au niveau de la grille du transistor.

Par « haute résistivité électrique », on entend dans le présent texte une résistivité électrique supérieure ou égale à 100 Ω.cm.

Par « SiC semi-isolant », on entend dans le présent texte du carbure de silicium présentant une résistivité électrique supérieure ou égale à 10⁵ Ω.cm.

Ce procédé permet de former un substrat à base de silicium ou d'un autre matériau de haute résistivité électrique à bas coût et disponible en grande dimension, comprenant une couche de SiC semi-isolant présentant une qualité cristalline adaptée à la croissance épitaxiale ultérieure d'une couche de l'alliage III-N et faisant bénéficier la structure finale de ses bonnes propriétés de dissipation thermique et de limitation des pertes RF. La couche de SiC semi-isolant étant en contact direct avec le substrat de silicium (ou autre matériau de haute résistivité électrique), la structure ne contient en outre aucune barrière thermique.

Un procédé qui consisterait à former la couche de SiC semi-isolant par épitaxie directement sur un substrat de silicium de haute résistivité électrique conduirait à former un grand nombre de dislocations dans le SiC semi-isolant en raison de la différence de paramètre de maille entre le silicium et le carbure de silicium. Au contraire, le procédé selon l'invention permet d'utiliser comme germe pour la croissance du SiC semi-isolant une couche de SiC monocristallin de qualité optimale car obtenue par transfert du substrat donneur.

Par ailleurs, l'utilisation du premier substrat receveur, qui remplit la fonction de support temporaire, permet d'orienter la face silicium du SiC de manière optimale dans les différentes étapes du procédé.

Selon des caractéristiques avantageuses mais optionnelles du procédé, considérées séparément ou dans leurs combinaisons techniquement possibles :
- le premier substrat receveur et le substrat donneur présentent une différence de coefficient de dilatation thermique inférieure ou égale à 3×10⁻⁶ K⁻¹ ;
- le premier substrat receveur est un substrat de SiC présentant une qualité cristalline inférieure à celle du substrat donneur ;
- la couche mince de SiC monocristallin transférée sur le premier substrat receveur présente une épaisseur inférieure à 1 µm ;
- la couche de collage est formée en un matériau thermiquement stable pendant la croissance épitaxiale de la couche de SiC semi-isolant et apte à être retiré de l'interface entre la couche de SiC monocristallin transférée et du premier substrat receveur ;
- la couche de collage est une couche de nitrure de silicium ou de nitrure de gallium ;
- le retrait d'au moins une partie de la couche de collage comprend une gravure chimique, un délaminage par laser et/ou l'application d'une contrainte mécanique ;
- la couche de SiC semi-isolant est formée par dopage au vanadium pendant la croissance épitaxiale du SiC ;
- la couche de SiC semi-isolant est formée par dépôt simultané de silicium, de carbone et de vanadium ;
- le second substrat receveur est un substrat de silicium présentant une résistivité électrique supérieure ou égale à 100 Ω.cm ;
- la couche épitaxiale de SiC semi-isolant présente une épaisseur comprise entre 1 et 5 µm ;
- le second substrat receveur est un substrat de SiC polycristallin ou un substrat d'AIN polycristallin présentant une résistivité électrique supérieure ou égale à 100 Ω.cm ;
- la couche épitaxiale de SiC semi-isolant présente une épaisseur inférieure ou égale à 80 µm ;
- le procédé comprend en outre une étape de recyclage de la portion du substrat donneur détachée de la couche transférée, en vue de former un nouveau substrat donneur ;
- l'implantation des espèces ioniques est réalisée au travers de la face silicium du substrat donneur, et la face silicium du substrat donneur est collée sur le premier substrat receveur, de sorte que, après le retrait de la couche mince de SiC monocristallin transférée, la face silicium de la couche de SiC semi-isolant soit exposée.

Un autre objet de l'invention concerne un procédé de fabrication d'une couche d'un alliage III-N à base de gallium sur un substrat obtenu par le procédé qui vient d'être décrit.

Ledit procédé comprend :
- la fourniture d'un substrat fabriqué par le procédé tel que décrit ci-dessus,
- la croissance épitaxiale de la couche de nitrure de gallium sur la couche de SiC semi-isolant dudit substrat.

Dans certains modes de réalisation, la couche de nitrure de gallium présente une épaisseur comprise entre 1 et 2 µm.

Un autre objet de l'invention concerne un procédé de fabrication d'un transistor à haute mobilité d'électrons (HEMT) dans une telle couche d'alliage III-N.

Ledit procédé comprend :
- la fabrication par épitaxie d'une couche de nitrure de gallium, de nitrure de gallium et d'aluminium ou de nitrure de gallium et d'indium par le procédé tel que décrit plus haut,
- la formation d'une hétérojonction par épitaxie, sur ladite couche, d'une couche d'un matériau III-N différent du matériau de ladite couche,
- la formation d'un canal du transistor au niveau de ladite hétérojonction,
- la formation d'une source, d'un drain et d'une grille du transistor sur le canal.

### Brève description des dessins

D'autres caractéristiques et avantages de l'invention ressortiront de la description détaillée qui va suivre, en référence aux dessins annexés, sur lesquels :
La figure 1 est une vue schématique en coupe d'un substrat donneur de SiC monocristallin ;
La figure 2 est une vue schématique en coupe du substrat donneur de la figure 1 dans lequel une zone de fragilisation est formée par implantation d'espèces ioniques pour délimiter une couche mince à transférer ;
La figure 3 est une vue schématique en coupe d'un support temporaire recouvert d'une couche de collage démontable ;
La figure 4 est une vue schématique en coupe de l'assemblage du support temporaire de la figure 3 et du substrat donneur de la figure 2 par l'intermédiaire de la couche de collage démontable ;
La figure 5 est une vue schématique en coupe du détachement du substrat donneur le long de la zone de fragilisation pour transférer la couche mince de SiC monocristallin sur le support temporaire ;
La figure 6 est une vue schématique en coupe de la couche mince de SiC monocristallin transférée sur le support temporaire après polissage de sa surface libre ;
La figure 7 est une vue schématique en coupe de la formation par épitaxie d'une couche de SiC semi-isolant sur la couche mince de SiC monocristallin transférée ;
La figure 8 est une vue schématique en coupe de l'assemblage de la structure de la figure 7 et d'un substrat receveur par l'intermédiaire de la couche épitaxiale de SiC semi-isolant ;
La figure 9 est une vue schématique en coupe du démontage du support temporaire de la structure de la figure 8 ;
La figure 10 est une vue schématique en coupe du substrat receveur et de la couche épitaxiale de SiC semi-isolant après retrait de la couche mince de SiC monocristallin ;
La figure 11 est une vue schématique en coupe de la formation par épitaxie d'une couche de GaN sur la couche de SiC semi-isolant ;
La figure 12 est une vue schématique en coupe de la formation d'une hétérojonction par épitaxie d'une couche d'un alliage III-N différent du GaN sur la couche de GaN.

Pour des raisons de lisibilité des figures, les différentes couches n'ont pas nécessairement été réalisées à l'échelle.

### Description détaillée de modes de réalisation

L'invention propose un procédé de fabrication de substrats pour la croissance épitaxiale d'alliages III-N binaires ou ternaires à base de gallium. Lesdits alliages comprennent le nitrure de gallium (GaN), le nitrure de gallium et d'aluminium (AlₓGa₁₋ₓN, où 0 < x < 1, désigné par la suite de manière abrégée par AIGaN) et le nitrure de gallium et d'indium (InₓGa₁₋ₓN, où 0 < x < 1, désigné par la suite de manière abrégée par InGaN). Dans un souci de concision, on décrira dans la suite du texte la fabrication d'un substrat pour la croissance épitaxiale d'une couche de GaN mais l'homme du métier est à même d'adapter les conditions de croissance pour former une couche d'AlGaN ou d'IngaN, le substrat servant à cette croissance épitaxiale étant le même.

Le procédé utilise un substrat donneur de carbure de silicium (SiC) monocristallin semiconducteur dopé, dont une couche mince, transférée sur un premier substrat receveur, servira de germe à la croissance d'une couche de SiC semi-isolant. Dans la suite du texte, on considérera un transfert de couche par le procédé Smart Cut^{™}.

A cet effet, on choisit un substrat de SiC monocristallin présentant une excellente qualité cristalline, c'est-à-dire notamment exempt de dislocations.

Dans certains modes de réalisation, le substrat donneur peut être un substrat massif de SiC monocristallin. Dans d'autres formes de réalisation, le substrat donneur peut être un substrat composite, comprenant une couche superficielle de SiC monocristallin et au moins une autre couche d'un autre matériau. Dans ce cas, la couche de SiC monocristallin présente une épaisseur supérieure ou égale à 0,5 µm.

Il existe différentes formes cristallines (également appelées polytypes) du carbure de silicium. Les plus répandues sont les formes 4H, 6H et 3C. De manière préférée, le carbure de silicium monocristallin est choisi parmi les polytypes 4H et 6H, mais tous les polytypes sont envisageables pour mettre en oeuvre la présente invention.

Sur les figures, on a représenté un substrat massif 10 de SiC monocristallin.

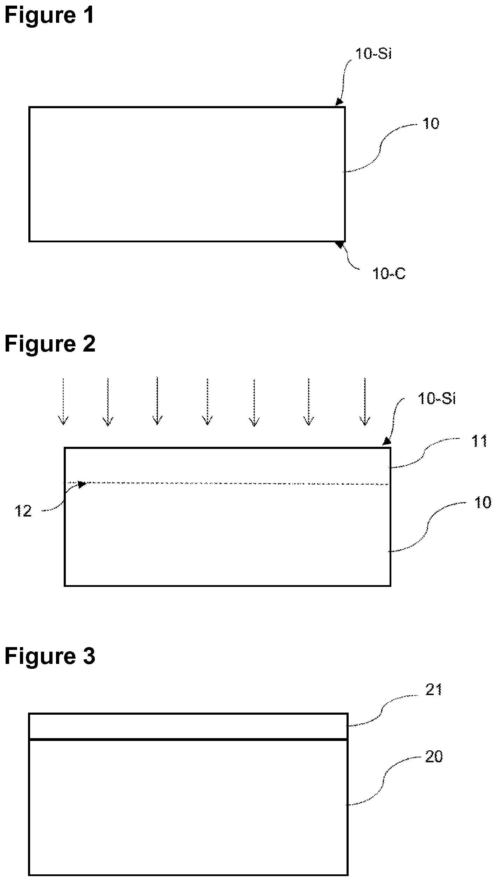

De manière connue en elle-même, comme illustré sur la figure 1, un tel substrat présente une face silicium 10-Si et une face carbone 10-C.

A l'heure actuelle, les procédés d'épitaxie de GaN sont principalement mis en oeuvre sur la face silicium du SiC. Cependant, il n'est pas exclu de parvenir à faire croître du GaN sur la face carbone du SiC. L'orientation du substrat donneur (face silicium / face carbone) pendant la mise en oeuvre du procédé est choisie en fonction de la face du SiC destinée à la croissance de la couche de GaN.

En référence à la figure 2, on met en oeuvre une implantation d'espèces ioniques dans le substrat donneur 10, de sorte à former une zone de fragilisation 12 délimitant une couche mince 11 de SiC monocristallin. Les espèces implantées comprennent typiquement de l'hydrogène et/ou de l'hélium. L'homme du métier est à même de définir l'énergie et la dose d'implantation requises.

Lorsque le substrat donneur est un substrat composite, l'implantation est réalisée dans la couche superficielle de SiC monocristallin dudit substrat.

De manière préférée, l'implantation des espèces ioniques est réalisée au travers de la face silicium 10-Si du substrat donneur. Comme on le verra par la suite, cette orientation du substrat donneur permet d'obtenir, à la surface du substrat final destiné à la croissance de la couche de GaN, la face silicium du SiC, qui est plus favorable. Cependant, si la croissance de la couche de GaN est envisagée sur la face carbone du SiC, l'implantation des espèces ioniques doit être réalisée au travers de la face carbone 10-C du substrat donneur.

De préférence, la couche mince 11 de SiC monocristallin présente une épaisseur inférieure à 1 µm. Une telle épaisseur est en effet accessible à l'échelle industrielle avec le procédé Smart Cut^{™}. En particulier, les dispositifs d'implantation disponibles dans les lignes de fabrications industrielles permettent d'atteindre une telle profondeur d'implantation.

En référence à la figure 3, on fournit par ailleurs un premier substrat receveur 20.

La fonction principale dudit premier substrat receveur est de supporter temporairement la couche 11 de SiC monocristallin entre son transfert depuis le substrat donneur et la croissance d'une couche de SiC semi-isolante sur la couche de SiC monocristallin.

A cet effet, le premier substrat receveur est choisi pour présenter un coefficient de dilatation thermique sensiblement égal à celui du SiC, afin de ne pas induire de contraintes ou de déformations lors de l'épitaxie du SiC semi-isolant. Ainsi, de manière particulièrement avantageuse, le premier substrat receveur et le substrat donneur (ou la couche de SiC monocristallin dans le cas d'un substrat donneur composite) présentent une différence de coefficient de dilatation thermique inférieure ou égale à 3×10⁻⁶ K⁻¹. De préférence, le premier substrat receveur est également en SiC de manière à minimiser la différence de coefficient de dilatation thermique. De manière particulièrement avantageuse, le premier substrat receveur 20 est un substrat de SiC présentant une qualité cristalline inférieure à celle du substrat donneur. On entend par là que le premier substrat receveur peut être un substrat de SiC polycristallin, ou bien un substrat de SiC monocristallin mais pouvant comprendre des dislocations de tous types (contrairement au SiC monocristallin du substrat donneur qui est choisi d'une excellente qualité cristalline afin d'assurer la qualité de la couche épitaxiale de GaN). Un tel substrat de qualité cristalline inférieure présente l'avantage d'être moins onéreux qu'un substrat de même qualité que le substrat donneur, tout étant parfaitement adapté à la fonction de support temporaire.

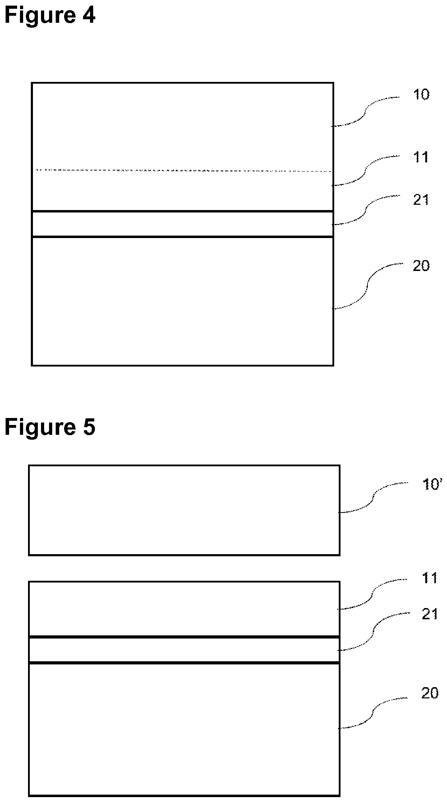

En référence à la figure 4, on colle le substrat donneur 10 comprenant la couche mince 11 de SiC monocristallin sur le premier substrat receveur 20.

Pour assurer une bonne adhésion du substrat donneur sur le premier substrat donneur, on forme une couche de collage 21 à l'interface entre lesdits substrats.

Sur la figure 3, la couche de collage 21 est formée sur le premier substrat receveur 20, mais, dans d'autres modes de réalisation non illustrés, la couche de collage peut être formée sur le substrat donneur (du côté de la couche mince 11), ou bien en partie sur le substrat donneur et en partie sur le premier substrat receveur.

La couche de collage est formée en un matériau thermiquement stable pendant la croissance épitaxiale ultérieure du SiC semi-isolant sur la couche mince 11.

A titre indicatif, l'épitaxie de 4H ou 6H-SiC étant réalisée à une température typiquement supérieure à 1500°C, le matériau de la couche de collage est choisi pour ne pas se dégrader ou se dissocier à une telle température.

Par ailleurs, le matériau de la couche de collage est apte à être retiré de l'interface entre la couche de SiC monocristallin transférée et du premier substrat receveur 20, par exemple au moyen d'une gravure sélective, éventuellement assistée par plasma. Selon un mode de réalisation préféré, la couche de collage est une couche de nitrure de silicium ou de nitrure de gallium. L'épaisseur de ladite couche est typiquement comprise entre 10 nm et quelques centaines de nanomètres.

En référence à la figure 5, on détache le substrat donneur le long de la zone de fragilisation 12. De manière connue en elle-même, le détachement peut être provoqué par un traitement thermique, une action mécanique, ou une combinaison de ces moyens. Ce détachement a pour effet de transférer la couche mince 11 de SiC monocristallin sur le premier substrat receveur 20. Le reliquat 10' du substrat donneur peut éventuellement être recyclé en vue d'une autre utilisation.

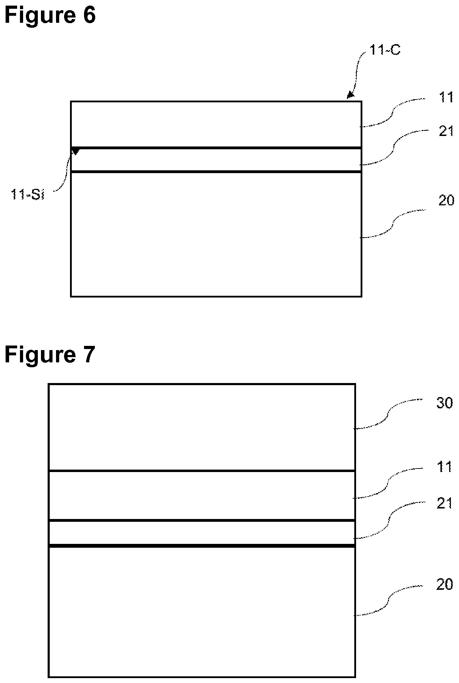

Comme illustré sur la figure 6, la face libre de la couche 11 de SiC monocristallin transférée est la face carbone 11-C (la face silicium 11-Si étant du côté de l'interface de collage). On met en oeuvre un polissage de cette face, par exemple par un polissage mécano-chimique (CMP, acronyme du terme anglo-saxon « Chemical Mechanical Polishing ») pour retirer les défauts liés à l'implantation des espèces ioniques et réduire la rugosité de la couche 11.

En référence à la figure 7, on met en oeuvre une croissance épitaxiale d'une couche 30 de SiC semi-isolant sur la couche mince 11 de SiC monocristallin. Le polytype du SiC semi-isolant est avantageusement identique à celui du SiC du substrat donneur.

Cette croissance épitaxiale est réalisée à une température très élevée, généralement supérieure à 1500°C mais, comme expliqué plus haut, la couche de collage 21 est stable à cette température. De plus, compte tenu de la faible différence de coefficient de dilatation thermique entre le matériau du premier substrat receveur et le SiC, les contraintes mécaniques engendrées dans l'empilement sont minimisées.

Il existe différentes techniques pour former du SiC semi-isolant. Selon un mode de réalisation, on dope au vanadium la couche de SiC pendant sa croissance épitaxiale. Selon un autre mode de réalisation, on dépose simultanément du silicium, du carbone et du vanadium, en utilisant des précurseurs adaptés dans un bâti d'épitaxie.

La couche de SiC semi-isolant présente avantageusement une épaisseur supérieure à 1 µm, de sorte à contribuer de manière significative à la dissipation thermique au sein de la structure finale. Cette épaisseur est plus élevée que l'épaisseur accessible directement par le procédé Smart Cut^{™} avec les équipements disponibles industriellement.

Ainsi, le procédé consistant à transférer une couche de SiC monocristallin avec une épaisseur inférieure à 1 µm puis à former une couche monocristalline de SiC monocristallin par épitaxie sur ladite couche transférée permet de contourner les limites techniques des équipements d'implantation disponibles industriellement pour la mise en oeuvre du procédé Smart Cut^{™}. Par ailleurs, ce procédé ne nécessite pas un substrat donneur en SiC semi-isolant (qui serait particulièrement coûteux) ; en effet, la couche transférée ayant essentiellement une fonction de couche germe pour la formation de la couche de dissipation thermique en SiC semi-isolant, l'utilisation de SiC monocristallin de résistivité électrique standard pour former la couche transférée est suffisante.

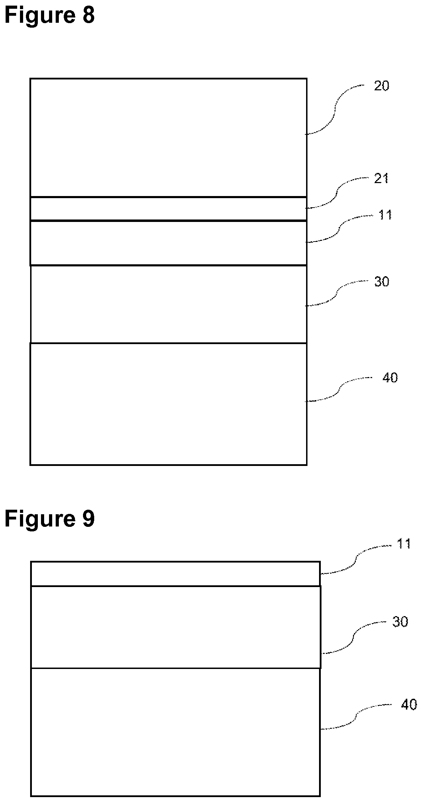

En référence à la figure 8, on fournit un second substrat receveur 40 qui présente une haute résistivité électrique, et on le colle sur la couche 30 de SiC semi-isolant. Par exemple, le second substrat receveur peut être un substrat de silicium présentant une résistivité électrique supérieure ou égale à 100 Ω.cm, un substrat de SiC polycristallin ou un substrat d'AIN polycristallin, présentant également une résistivité électrique supérieure ou égale à 100 Ω.cm.

Selon le matériau du second substrat receveur, l'épaisseur de la couche 30 de SiC semi-isolant pourra être adaptée. Ainsi, lorsque le second substrat receveur est un substrat de silicium de haute résistivité électrique, la couche 30 de SiC semi-isolant présentera avantageusement une épaisseur comprise entre 1 et 5 µm. Lorsque le second substrat receveur est un substrat de SiC polycristallin ou d'AIN polycristallin, il pourra être avantageux de former la couche 30 de SiC semi-isolant sur une épaisseur beaucoup plus importante, pouvant atteindre 80 µm, par exemple de l'ordre de 50 à 80 µm, pour améliorer la dissipation thermique au sein de la structure finale.

On retire ensuite au moins une partie de la couche de collage 21, de sorte à détacher le premier substrat receveur du reste de la structure. Lors de ce retrait, la couche 21 doit être suffisamment endommagée pour permettre une dissociation de la structure. Tout moyen adapté peut être employé. Par exemple, mais de manière non limitative, le retrait de la couche de collage peut être réalisé par une gravure chimique, un délaminage par laser et/ou l'application d'une contrainte mécanique.

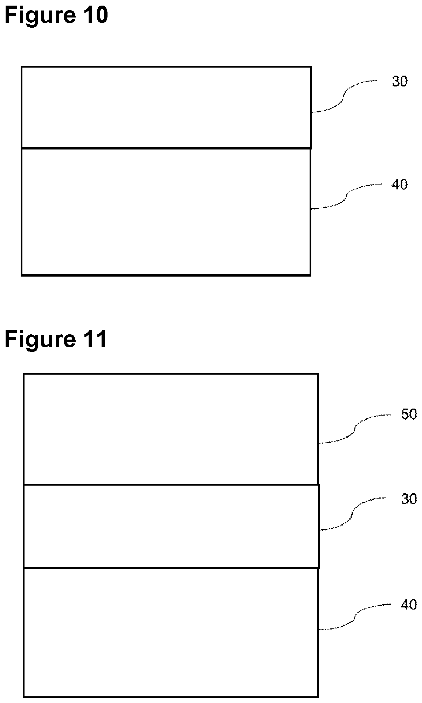

Comme illustré sur la figure 9, il subsiste donc, à l'issue de cette séparation, une structure constituée successivement du second substrat receveur 40, de la couche 30 de SiC semi-isolant et de la couche mince transférée 11 de SiC monocristallin. Les éventuels résidus de la couche de collage 21 ont été retirés par polissage et/ou gravure. En référence à la figure 10, on retire la couche mince 11, de sorte à exposer la couche 30 de SiC semi-isolant. Le retrait de la couche mince 11 peut être réalisé par tout moyen approprié, tel qu'une gravure chimique ou mécanique.

La face exposée est la face silicium du SiC semi-isolant, qui est favorable à la croissance épitaxiale du GaN. On a ainsi formé un substrat adapté pour la croissance épitaxiale d'alliages III-N.

En référence à la figure 11, on fait croître, sur la face libre de la couche 30 de SiC semi-isolant, une couche 50 de GaN (ou, comme mentionné plus haut, d'AlGaN ou d'InGaN). L'épaisseur de la couche 50 est typiquement comprise entre 1 et 2 µm.

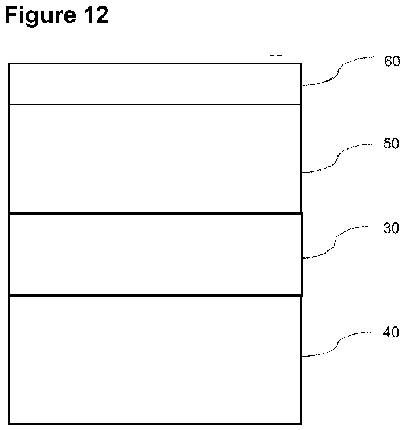

Ensuite, comme illustré sur la figure 12, on forme une hétérojonction en faisant croître par épitaxie, sur la couche 50, une couche 60 d'un alliage III-N différent de celui de la couche 50.

On peut ainsi poursuivre la fabrication de transistors, notamment de transistors HEMT, à partir de cette hétérojonction, par des procédés connus de l'homme du métier, le canal du transistor étant formé au niveau de l'hétérojonction, et la source, le drain et la grille du transistor étant formés sur le canal.

La structure ainsi obtenue est particulièrement intéressante en ce qu'elle comprend une couche relativement épaisse de SiC semi-isolant, qui d'une part sert de germe à la croissance épitaxiale de la couche d'alliage III-N et qui d'autre part procure une bonne dissipation thermique et une limitation des pertes RF. Par ailleurs, le second substrat receveur, qui supporte la couche de SiC semi-isolant, est directement en contact avec ladite couche, de sorte que la structure ne comporte pas de barrière thermique.

Ainsi, un transistor HEMT ou un autre dispositif électronique à haute fréquence et forte puissance formé dans une couche d'alliage II-N formée par épitaxie sur une telle structure présente des pertes RF minimisées et une dissipation thermique maximisée.

### Références

[1] Comparative study on stress in AIGaN/GaN HEMT structures grown on 6H-SiC, Si and on composite substrates of the 6H-SiC/poly-SiC and Si/poly-SiC, M. Guziewicz et al, Journal of Physics: Conférence Series 100 (2008) 040235

## Revendications

1. Procédé de fabrication d'un substrat pour la croissance épitaxiale d'une couche de nitrure de gallium (GaN), de nitrure de gallium et d'aluminium (AIGaN) ou de nitrure de gallium et d'indium (InGaN), comprenant les étapes successives suivantes :
- fourniture d'un substrat donneur (10) de carbure de silicium monocristallin,
- implantation d'espèces ioniques dans le substrat donneur (10) de sorte à former une zone de fragilisation (12) délimitant une couche mince (11) de SiC monocristallin à transférer,
- collage du substrat donneur (10) sur un premier substrat receveur (20) par l'intermédiaire d'une couche de collage (21),
- détachement du substrat donneur (10) le long de la zone de fragilisation (12) de sorte à transférer la couche mince (11) de SiC sur le premier substrat receveur (20),
- croissance épitaxiale d'une couche (30) de SiC semi-isolant présentant une épaisseur supérieure à 1 µm sur la couche mince (11) de SiC,
- collage de la couche (30) de SiC semi-isolant sur un second substrat receveur (40), ledit second substrat receveur (40) présentant une haute résistivité électrique,
- retrait d'au moins une partie de la couche de collage (21) de sorte à détacher le premier substrat receveur (20),
- retrait de la couche mince (11) de SiC monocristallin transférée, de sorte à exposer la couche (30) de SiC semi-isolant.

2. Procédé selon la revendication 1, dans lequel le premier substrat receveur (20) et le substrat donneur (10) présentent une différence de coefficient de dilatation thermique inférieure ou égale à 3×10⁻⁶ K⁻¹.

3. Procédé selon l'une des revendications 1 ou 2, dans lequel le premier substrat receveur (20) est un substrat de SiC présentant une qualité cristalline inférieure à celle du substrat donneur.

4. Procédé selon l'une des revendications 1 à 3, dans lequel la couche de collage (21) est formée en un matériau thermiquement stable pendant la croissance épitaxiale de la couche (30) de SiC semi-isolant et apte à être retiré de l'interface entre la couche (11) de SiC monocristallin transférée et du premier substrat receveur (20).

5. Procédé selon l'une des revendications 1 à 4, dans lequel la couche de collage (21) est une couche de nitrure de silicium ou de nitrure de gallium.

6. Procédé selon l'une des revendications 1 à 5, dans lequel le retrait d'au moins une partie de la couche de collage (21) comprend une gravure chimique, un délaminage par laser et/ou l'application d'une contrainte mécanique.

7. Procédé selon l'une des revendications 1 à 6, dans lequel la couche (30) de SiC semi-isolant est formée par dopage au vanadium pendant la croissance épitaxiale du SiC ou formée par dépôt simultané de silicium, de carbone et de vanadium.

8. Procédé selon l'une des revendications 1 à 7, dans lequel le second substrat receveur (40) est un substrat de silicium présentant une résistivité électrique supérieure ou égale à 100 Ω.cm et dans lequel la couche épitaxiale (30) de SiC semi-isolant présente une épaisseur comprise entre 1 et 5 µm.

9. Procédé selon l'une des revendications 1 à 8, dans lequel le second substrat receveur (40) est un substrat de SiC polycristallin ou un substrat d'AIN polycristallin présentant une résistivité électrique supérieure ou égale à 100 Ω.cm.

10. Procédé selon la revendication 9, dans lequel la couche épitaxiale (30) de SiC semi-isolant présente une épaisseur inférieure ou égale à 80 µm.

11. Procédé selon l'une des revendications 1 à 10, comprenant en outre une étape de recyclage de la portion (10') du substrat donneur détachée de la couche (11) transférée, en vue de former un nouveau substrat donneur.

12. Procédé selon l'une des revendications 1 à 11, dans lequel :
- l'implantation des espèces ioniques est réalisée au travers de la face silicium (10-Si) du substrat donneur (10),
- la face silicium (10-Si) du substrat donneur (10) est collée sur le premier substrat receveur (20),
de sorte que, après le retrait de la couche mince (11) de SiC monocristallin transférée, la face silicium de la couche (30) de SiC semi-isolant soit exposée.

13. Procédé de fabrication par épitaxie d'une couche de nitrure de gallium, comprenant :
- la fourniture d'un substrat fabriqué par le procédé selon l'une des revendications 1 à 12,
- la croissance épitaxiale de la couche (50) de nitrure de gallium sur la couche (30) de SiC semi-isolant dudit substrat.

14. Procédé selon la revendication 13, dans lequel la couche (50) de nitrure de gallium présente une épaisseur comprise entre 1 et 2 µm.

15. Procédé de fabrication d'un transistor à haute mobilité d'électrons (HEMT), comprenant :
- la fabrication par épitaxie d'une couche (50) de nitrure de gallium, de nitrure de gallium et d'aluminium ou de nitrure de gallium et d'indium par le procédé selon l'une des revendications 13 ou 14,
- la formation d'une hétérojonction par épitaxie, sur ladite couche (50), d'une couche (60) d'un matériau III-N différent du matériau de ladite couche (50),
- la formation d'un canal du transistor au niveau de ladite hétérojonction,
- la formation d'une source, d'un drain et d'une grille du transistor sur le canal.

## Patentansprüche

1. Verfahren zur Herstellung eines Substrats für das epitaktische Wachstum einer Schicht aus Galliumnitrid (GaN), Galliumaluminiumnitrid (AlGaN) oder aus Galliumindiumnitrid (InGaN), das die folgenden aufeinanderfolgenden Schritte umfasst:
- Bereitstellen eines Donorsubstrats (10) aus monokristallinem Siliciumkarbid,
- Implantieren von ionischen Spezies in das Donorsubstrat (10), so dass eine Schwächungszone (12) gebildet wird, die eine dünne Schicht (11) aus zu übertragendem monokristallinem SiC begrenzt,
- Verkleben des Donorsubstrats (10) auf einem ersten Empfängersubstrat (20) anhand einer Verklebungsschicht (21),
- Ablösen des Donorsubstrats (10) entlang der Schwächungszone (12), so dass die dünne Schicht (11) aus SiC auf das erste Empfängersubstrat (20) übertragen wird,
- epitaktisches Wachstum einer Schicht (30) aus halbisolierendem SiC mit einer Dicke von mehr als 1 µm auf der dünnen Schicht (11) aus SiC,
- Verkleben der Schicht (30) aus halbisolierendem SiC mit einem zweiten Empfängersubstrat (40), wobei das zweite Empfängersubstrat (40) einen hohen spezifischen elektrischen Widerstand aufweist,
- Entfernen von mindestens einem Teil der Verklebungsschicht (21), um das erste Empfängersubstrat (20) zu abzulösen,
- Entfernen der übertragenen dünnen Schicht (11) aus monokristallinem SiC, so dass die Schicht (30) aus halbisolierendem SiC freigelegt wird.

2. Verfahren nach Anspruch 1, wobei das erste Empfängersubstrat (20) und das Donorsubstrat (10) einen Unterschied im thermischen Ausdehnungskoeffizienten von weniger als oder gleich 3×10⁻⁶ K⁻¹ aufweisen.

3. Verfahren nach einem der Ansprüche 1 oder 2, wobei das erste Empfängersubstrat (20) ein SiC-Substrat ist, das eine geringere Kristallqualität als das Donorsubstrat aufweist.

4. Verfahren nach einem der Ansprüche 1 bis 3, wobei die Verklebungsschicht (21) aus einem während des epitaktischen Wachstums der Schicht (30) aus halbisolierenden SiC aus thermisch stabilem Material gebildet wird und geeignet ist, von der Grenzfläche zwischen der übertragenen Schicht (11) aus monokristallinen SiC und dem ersten Empfängersubstrat (20) entfernt zu werden.

5. Verfahren nach einem der Ansprüche 1 bis 4, wobei die Verklebungsschicht (21) eine Schicht aus Siliciumnitrid oder Galliumnitrid ist.

6. Verfahren nach einem der Ansprüche 1 bis 5, wobei das Entfernen von mindestens einem Teil der Verklebungsschicht (21) chemisches Ätzen, Laser-Delaminieren und/oder die Anwendung von mechanischer Belastung umfasst.

7. Verfahren nach einem der Ansprüche 1 bis 6, wobei die Schicht (30) aus halbisolierendem SiC durch Vanadiumdotierung während des epitaktischen Wachstums des SiC oder durch gleichzeitiges Aufbringen von Silicium, Kohlenstoff und Vanadium gebildet wird.

8. Verfahren nach einem der Ansprüche 1 bis 7, wobei das zweite Empfängersubstrat (40) ein Siliciumsubstrat mit einem spezifischen elektrischen Widerstand von 100 Q.cm oder mehr ist und wobei die epitaktische Schicht (30) aus halbisolierendem SiC eine Dicke zwischen 1 und 5 µm aufweist.

9. Verfahren nach einem der Ansprüche 1 bis 8, wobei das zweite Empfängersubstrat (40) ein polykristallines SiC-Substrat oder ein polykristallines AIN-Substrat mit einem spezifischen elektrischen Widerstand von 100 Q.cm oder mehr ist.

10. Verfahren nach Anspruch 9, wobei die epitaktische Schicht (30) aus halbisolierendem SiC eine Dicke von 80 µm oder weniger aufweist.

11. Verfahren nach einem der Ansprüche 1 bis 10, das ferner einen Schritt umfasst, bei dem der von der übertragenen Schicht (11) abgelöste Abschnitt (10') des Donorsubstrats recycelt wird, um ein neues Donorsubstrat zu bilden.

12. Verfahren nach einem der Ansprüche 1 bis 11, wobei:
- die Implantation der ionischen Spezies durch die Siliciumseite (10-Si) des Donorsubstrats (10) hindurch erfolgt,
- die Siliciumseite (10-Si) des Donorsubstrats (10) auf dem ersten Empfängersubstrat (20) verklebt wird,
so dass nach dem Entfernen der übertragenen dünnen Schicht (11) aus monokristallinem SiC die Siliciumseite der Schicht (30) aus halbisolierendem SiC freigelegt wird.

13. Verfahren zur epitaktischen Herstellung einer Schicht aus Galliumnitrid, umfassend:
- die Bereitstellung eines Substrats, das anhand des Verfahrens nach einem der Ansprüche 1 bis 12 hergestellt wurde,
- das epitaktische Wachstum der Schicht (50) aus Galliumnitrid auf der Schicht (30) aus halbisolierendem SiC des Substrats.

14. Verfahren nach Anspruch 13, wobei die Schicht (50) aus Galliumnitrid eine Dicke zwischen 1 und 2 µm aufweist.

15. Verfahren zur Herstellung eines Transistors mit hoher Elektronenbeweglichkeit (HEMT), umfassend:
- die epitaktische Herstellung einer Schicht (50) aus Galliumnitrid, Galliumaluminiumnitrid oder Galliumindiumnitrid anhand des Verfahrens nach einem der Ansprüche 13 oder 14,
- die Bildung eines Heteroübergangs durch Epitaxie einer Schicht (60) aus einem III-N-Material, das sich von dem Material der Schicht (50) unterscheidet, auf der Schicht (50),
- die Bildung eines Transistorkanals im Bereich des Heteroübergangs,
- die Bildung einer Source, eines Drains und eines Gates des Transistors auf dem Kanal.

## Claims

1. Process for manufacturing a substrate for epitaxial growth of a gallium nitride (GaN), gallium aluminum nitride (AlGaN) or gallium indium nitride (InGaN) layer, comprising the following successive steps:
- supply of a donor substrate (10) of single-crystal silicon carbide,
- implantation of ionic species in the donor substrate (10) to form an embrittlement zone (12) delimiting a thin layer (11) of single-crystal SiC to be transferred,
- bonding the donor substrate (10) to a first recipient substrate (20) via a bonding layer (21),
- detachment of the donor substrate (10) along the embrittlement zone (12) so as to transfer the SiC thin film (11) onto the first recipient substrate (20),
- epitaxial growth of a semi-insulating SiC layer (30) thicker than 1 µm on the SiC thin film (11),
- bonding the semi-insulating SiC layer (30) to a second receiving substrate (40), said second receiving substrate (40) having a high electrical resistivity,
- removal of at least a part of the bonding layer (21) so as to detach the first receiving substrate (20),
- removal of the transferred single-crystal SiC thin film (11) to expose the semi-insulating SiC layer (30).

2. Process according to claim 1, in which the first receiving substrate (20) and the donor substrate (10) have a difference in coefficient of thermal expansion less than or equal to 3×10⁻⁶ K⁻¹ .

3. Process according to one of claims 1 or 2, in which the first recipient substrate (20) is an SiC substrate with a lower crystal quality than the donor substrate.

4. Process according to one of claims 1 to 3, in which the bonding layer (21) is formed from a material that is thermally stable during epitaxial growth of the semi-insulating SiC layer (30) and is removable from the interface between the transferred single-crystal SiC layer (11) and the first receiving substrate (20).

5. Process according to one of claims 1 to 4, wherein the bonding layer (21) is a silicon nitride or gallium nitride layer.

6. Process according to one of claims 1 to 5, wherein removal of at least part of the bonding layer (21) comprises chemical etching, laser delamination and/or application of mechanical stress.

7. Process according to one of claims 1 to 6, in which the semi-insulating SiC layer (30) is formed by vanadium doping during SiC epitaxial growth or formed by simultaneous deposition of silicon, carbon and vanadium.

8. Process according to one of claims 1 to 7, in which the second receiving substrate (40) is a silicon substrate having an electrical resistivity greater than or equal to 100 Ω.cm and in which the epitaxial layer (30) of semi-insulating SiC has a thickness of between 1 and 5 µm.

9. Process according to one of claims 1 to 8, wherein the second receiving substrate (40) is a polycrystalline SiC substrate or a polycrystalline AIN substrate having an electrical resistivity greater than or equal to 100 Ω.cm.

10. Process according to claim 9, in which the semi-insulating SiC epitaxial layer (30) has a thickness of 80 µm or less.

11. Process according to one of claims 1 to 10, further comprising a step of recycling the portion (10') of the donor substrate detached from the transferred layer (11), in order to form a new donor substrate.

12. Process according to one of claims 1 to 11, wherein:
- ionic species are implanted through the silicon face (10-Si) of the donor substrate (10),
- the silicon face (10-Si) of the donor substrate (10) is bonded to the first recipient substrate (20),
so that, after removal of the transferred single-crystal SiC thin film (11), the silicon face of the semi-insulating SiC layer (30) is exposed.

13. Method of epitaxially manufacturing a gallium nitride layer, comprising:
- the supply of a substrate manufactured by the process according to one of claims 1 to 12,
- epitaxial growth of the gallium nitride layer (50) on the semi-insulating SiC layer (30) of said substrate.

14. Process according to claim 13, in which the gallium nitride layer (50) has a thickness of between 1 and 2 µm.

15. A method of manufacturing a high electron mobility transistor (HEMT), comprising:
- epitaxial manufacture of a gallium nitride, gallium-aluminum nitride or gallium-indium nitride layer (50) by the process of one of claims 13 or 14,
- forming a heterojunction by epitaxially bonding to said layer (50) a layer (60) of III-N material different from the material of said layer (50),
- forming a transistor channel at said heterojunction,
- the formation of a transistor source, drain and gate on the channel.
